Europäisches Patentamt

European Patent Office

Office européen des brevets

(11) Publication number : **0 671 482 A1**

# (12) EUROPEAN PATENT APPLICATION

(21) Application number : 95301368.7

(22) Date of filing : 03.03.95

(51) Int. Cl.$^6$ : **C23C 16/26,** B05D 3/06, B01J 3/06

(30) Priority : 11.03.94 US 209938

(43) Date of publication of application :
13.09.95 Bulletin 95/37

(84) Designated Contracting States :
BE DE ES FR GB IT

(71) Applicant : GENERAL ELECTRIC COMPANY
1 River Road
Schenectady, NY 12345 (US)

(72) Inventor : Anthony, Thomas Richard
2142 Lynnwood Drive
Niskayuna, New York 12309 (US)

Inventor : Banholzer, William Frank
1046 Bluffpoint Drive
Columbus, Ohio 43235 (US)
Inventor : Spiro, Clifford Lawrence
2801 Troy Road
Niskayuna, New York 12309 (US)
Inventor : Webb, Steven William
1492 Buck Rub Court
Worthington, Ohio 43085 (US)
Inventor : Williams, Bradley Earl
544 Riley Avenue
Worthington, Ohio 43085 (US)

(74) Representative : Szary, Anne Catherine et al
London Patent Operation,
GE Technical Services Co. Inc.,
Essex House,
12-13 Essex Street
London WC2R 3AA (GB)

(54) Toughened chemically vapor deposited diamond.

(57) A chemically vapor deposited diamond body which has reduced density and stress gradients comprises compressed voids and is produced from a low pressure chemically vapor depositing diamond body by treating the body at sufficient temperatures and pressures at which diamond is the thermodynamically stable phase of carbon so as to reduce the size of the voids and reduce the stresses in the diamond body.

FIGURE 1

EP 0 671 482 A1

## TECHNICAL FIELD OF THE INVENTION

The present invention relates to a process for enhancing the properties of low pressure chemical vapor deposited (CVD) diamond and the enhanced product resulting from such treatment.

## BACKGROUND OF THE INVENTION

In one example, as-grown CVD diamond windows must have the highest possible transmission of laser light. The presence of grain boundaries, defects, dislocations, plastic strain and other sources of density fluctuation within the diamond window reduce its transmission, increase its absorption of incident radiation and reduce its thermal conductivity. Absorption of laser energy creates heat within the window which must be drained through the diamond body to an adjacent heat sink in contact with the diamond part. If heat dissipation is rate limiting, the temperature of the window will increase causing distortion of the window-fixture and the entire window-mount to fail. Density fluctuations of CVD diamond cannot be mechanically removed as they are produced by perturbations in the growth environment and are difficult to eliminate in as-grown wafers.

Thermal annealing may be utilized for reducing density fluctuations within an imperfect single- or polycrystalline body. However, with diamond, temperatures required to anneal it at reasonable rates are necessarily so high that the kinetic stability of diamond is reduced and the diamond reverts to graphite. Graphitization usually occurs within the crystal body at defects, boundaries and microcracks, forming darkened regions within the body. This exacerbates density gradients and weakens the crystal which can crack and destroy the wafer.

In another example, diamond tool blanks, wire drawing dies, wire guides, optical, acoustic, thermal management or other thermomechanical components, are made of diamond because of the desirable properties of diamond including wear resistance, transparency, high thermal conductivity, high electrical resistance, chemical inertness, low coefficient of friction, high modulus and high speed of sound. Currently diamond products are made of single-crystal gemstones which are costly, limited in size, contain impurities and wear unevenly due to the inherent anisotropy in the diamond lattice. Polycrystalline diamond products dies are also known, and are prepared by sintering diamond powder. Sintering eliminates the inherent anisotropy of single crystal diamond, and can make products much larger than single crystals, but the diamond suffers from defects and grain pullouts where insufficient sintering has taken place. The sintered products also incorporate metals or other elements which were used to catalyze the sintering process. This adds inherent weakness to the part since the metal bonds are not as strong as the diamond bonds. Metals are another source of density fluctuation which inhibit thermal conductivity, destroy optical transparency, reduce the speed of sound, raise the coefficient of friction, and decrease electrical resistivity.

It is now possible to prepare substantially metal-free polycrystalline diamond films by several methods well-known to those skillful in the art and broadly categorized as CVD or chemical vapor deposition. In general, diamond films are prepared by energetically decomposing hydrocarbonaceous gases (sometimes accompanied by other oxo-, nitrido- or halo-species) using microwave plasma, RF plasma, DC arc, DC plasma, flame, passage over an incandescent filament, through electron cyclotron resonance, or by laser ablation.

However, polycrystalline diamond films prepared by CVD methods suffer from visual and mechanical defects associated with grain boundaries and growth defects including voids. In addition, residual stresses associated with the growth processes may be undesirable. Subsequent use of CVD polycrystalline diamond films in tool, electro-optical applications, and so on may be inhibited by the presence of these defects.

## SUMMARY OF THE INVENTION

Heretofore, prior art process have concentrated on process changes during the CVD process to improve the characteristics of the resulting low pressure chemically vapor deposited diamond. However, certain deleterious properties result from the nature of the process. The process of the present invention enhances the properties of CVD diamond by a treatment after the initial deposition. The present invention desirably reduces the size of voids and reduces strain in low pressure CVD diamond so as to obtain enhanced properties. A high purity CVD diamond structure having voids of reduced size enhances optical transmission, toughness, strength, wear, and uniformity of wear properties of the CVD diamond.

It has been found that the improved CVD diamond structure can be produced by treating CVD diamond at high temperature and pressure conditions which inhibit spontaneous graphitization. This way high temperatures can be used to accelerate the rate of the process, while maintaining the equilibrium stability of the crystal framework to produce having enhanced properties.

In accordance with the present invention, there is provided a process for producing a diamond body having reduced stress and reduced density gradients comprising treating a chemically vapor deposited diamond body having voids at sufficient temperatures and pressures wherein diamond is the thermodynamically stable phase of carbon to reduce the size of the voids to form a diamond body of reduced density gradients.

Also, in accordance with the present invention there is provided a chemically vapor deposited diamond body having reduced density gradients comprising a low pressure chemically vapor deposited diamond body having compressed voids comprising a gaseous material.

In accordance with preferred embodiments, the present process anneals the low pressure chemically vapor deposited diamond body through the process of bringing the diamond part into high pressure, high temperature conditions in which diamond is the thermodynamically stable carbon phase and holding at these conditions for a prescribed period of time. Under these conditions, plastic deformation occurs as well as sufficient mobility is afforded the atoms which comprise the defect sites and along the interfaces of same such that the defects are removed. Subsequent cooling of the diamond film and release of pressure reveals a polycrystalline product which has reduced defects, lower stress, and is sufficient for subsequent finishing and use in any number of applications.

## BRIEF DESCRIPTION OF THE DRAWING

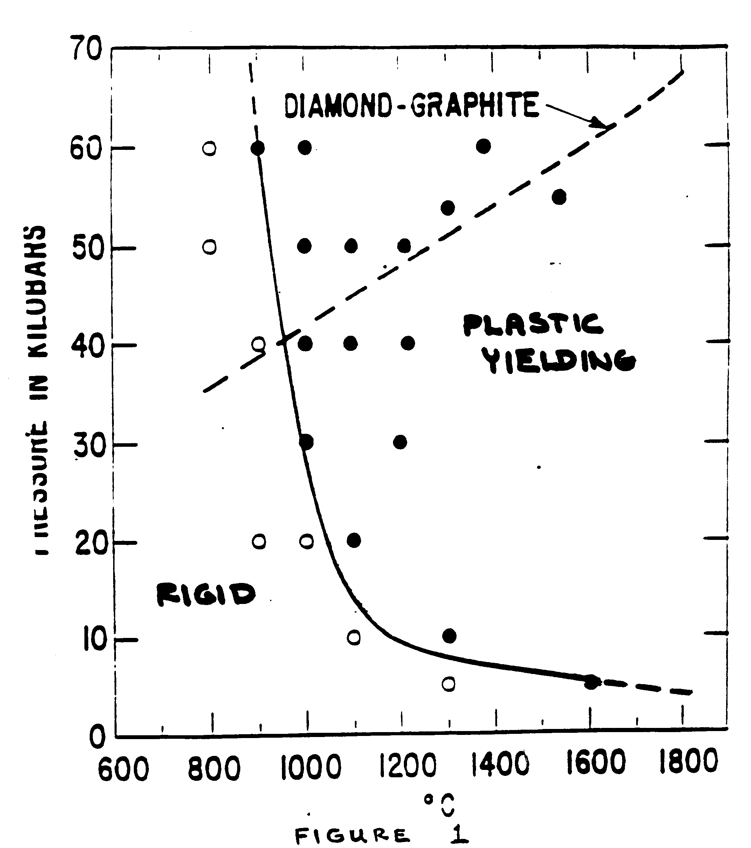

FIG. 1 shows a graph of the yield strength of diamond versus temperature (P-T line), and the DIAMOND-GRAPHITE line from DeVries, Mat. Res. Bull., 10, 1193-1200 (1975).

## DETAILED DESCRIPTION

A CVD diamond having enhanced properties characterized by reduced density gradients is formed by a post treatment of a starting low pressure produced CVD diamond. The starting CVD diamond utilized in the process of the present invention is a CVD diamond made by processes known in the art. Typically, processes for producing low pressure CVD diamond comprise microwave CVD, RFCVD, DCjet CVD, combustion flame CVD, or filament. A filament process for forming a CVD diamond substrate is set forth in U.S. patent 5,110,579 to Anthony et al. According to the processes set forth in the patent, diamond is grown by chemical vapor deposition on a substrate such as molybdenum by a filament process. According to this process, an appropriate mixture such as set forth in the example is passed over a filament for an appropriate length of time to build up the substrate to a desired thickness and create a diamond film.

It has been found that in the deposition of diamond films having crystals greater than about 50 micron and thicknesses greater than about 500 micron, deleterious voids which detract from the final desirable properties of the diamond tend to form. Depending on the conditions of vapor deposition voids having diameters greater than about 20 microns may form. Hence, due the enhancement of such material by the utilization of the present invention, preferred starting CVD diamond films typically have crystals greater than about 50 microns, thicknesses greater than about 500 microns, and voids having diameters greater than about 20 microns. However, the process of the present invention may be to enhance CVD diamond with a thickness of greater than 50 microns, and 100 microns. When used as free-standing films, thicknesses greater than 200 microns are preferred for certain applications.

A preferred starting film as described in the above patent has substantially transparent columns of diamond crystals having a <110> orientation perpendicular to the base. Grain boundaries between adjacent diamond crystals having hydrogen atoms saturating dangling carbon bonds is preferred wherein at least 50 percent of the carbon atoms are believed to be tetrahedrally bonded based on Raman spectroscopy, infrared, NMR, and X-ray analysis. It is also contemplated that H, F, Cl, O or other atoms may saturate dangling carbon atoms.

Preferably the starting CVD diamond films are produced by processes in which the amount of impurities is at a very low level and the diamond CVD film consist entirely of diamond. Additional ingredients in the form of impurities and intentional additives are preferably present in amounts less than 4000 parts per million by weight, and more preferably less than 100 parts per million. The low level of impurities contributes to enhanced properties of the final CVD diamond having reduced density gradients.

The crystal size of the starting CVD diamond may vary greatly and is dependent on the nucleation of diamond. With a continued nucleation during the deposition process, submicron crystals of diamond may be attained. When the nucleation is limited to an initial nucleation at the diamond film, elongated diamond crystals up to the thickness of the substrate may be formed. Typically crystals have a length of less than 200 microns but longer crystals may be formed. The CVD diamond film preferably has a thermal conductivity of at least about 6 W/cm-K, more preferably at least about 9 W/cm-K, and most preferably at least about 12 W/cm-K. Thermal conductivity of the diamond film may be as high as about 21 W/cm-K. Techniques which can be used to measure thermal conductivity of the substantially transparent diamond film are by Mirage, shown by R.W. Pryor et al., proceedings of the Second International Conference on New Diamond Science and Technology, p 863 (1990).

The starting CVD diamond film preferably has good optical properties and can transmit light. These properties are preferred for producing a high-quality CVD diamond having reduced density gradients. The polycrystalline nature of diamond can result in light scatter which can interfere with clarity. In addition, a material of high refractive index can reflect incident light which also contributes to a reduction in transmittance. Hence, a starting CVD diamond having desirable clarity and refractive index is preferred.

The starting CVD diamond typically contains voids which are produced during the diamond deposition. The voids may contain gaseous constituents from the CVD deposition process. Gaseous constituents typically include hydrogen, nitrogen, oxygen, carbon dioxide, and carbon monoxide. In low pressure deposited CVD diamond, the voids may be on the order of 200 microns although preferred higher quality diamond has voids less than 10 microns in diameter.

The presence of voids acts to weaken the material and deleteriously effect the desirable properties of the CVD diamond. Voids apparently originate from neighboring crystals growing over one another and shielding part of the crystal surface from further growth. These voids may also appear as a result of internal relief of the intrinsic stresses associated with CVD diamond films. As growth proceeds, these small caverns become buried in the CVD diamond film and form the voids that are seen later when a film is cross-sectioned. Some evidence of the origin of these voids comes from their size and internal surfaces. Generally, the void size is proportional to the crystal size of the material in which it is found. The internal surfaces of the void are usually faceted and indicate the crystal-growth origin of the voids.

CVD films are typically columnar and start out with a very fine grain size on the initial nucleation surface. The grain size gradually expands because of competitive grain growth from the initial growth surface to the final growth surface. Consequently, the void size also increases across the film in proportion to the corresponding increase in grain size. Hence, larger voids on the order of 50 microns are typically associated with crystal sizes of 200 micron and film thicknesses greater than 500 microns. Voids are typically seen along grain boundaries. Their grain boundary location is another consequence of their origin during crystal growth.

In accordance with the principles of the present invention, it is desirable to reduce the size of voids in the starting CVD diamond so as to obtain CVD diamond with reduced density gradients. CVD diamond is typically grown in a low-pressure gas atmosphere of hydrogen and hydrocarbon and sometimes some additional gases such as oxygen. As a result, the voids in CVD diamond will contain these gases at low pressures and contribute to high density gradients. This is caused by a reduction in density of the diamond in the area of the void. Larger voids tend to cause a greater reduction in the density than smaller voids.

In many materials voids can be eliminated by holding the material close to its melting point. Vacancies on the surface of the void diffuse away to vacancy sinks driven by the chemical potential difference of $\gamma/r$ between the void and the vacancy sink, where g is the surface energy of the solid ($\gamma$-diamond =5300 erg/cm$^2$) and r is the radius of the void. A vacancy diffusing away from the void is equivalent to an atom diffusing into the void. In this manner, the void gradually fills in and disappears in a sintering type of process. Normally, such sintering processes would be carried out at a temperature in excess of 2/3 of the melting point of the material. However, in diamond, with an equivalent melting point of 3800°C this approach has not been possible because diamond is unstable and will carburize quickly when exposed to high temperatures. If the diamond is placed in a high-pressure press at 50kbar, the temperature can be raised routinely in the range of 1000-1600°C without leaving the diamond stable region.

The diffusion coefficient of carbon atoms in diamond is given by:

$$D=D_o \exp\{-Q/RT\} \qquad (1)$$

where $D_0$=116 cm$^2$/s and Q=143kcal/mol. The movement of carbon in diamond is by substitutional diffusion and so requires a neighboring vacancy. The activation energy Q is made up of the energy of formation of the vacancy plus the activation energy required for a carbon atom to jump over the potential barrier from its own site to the neighboring vacant site. In most solids, the energy of vacancy formation and the energy of activation over the potential barrier are approximately equal. If we make this assumption for diamond, the diffusion coefficient $D_v$ of a vacancy in diamond is given by:

$$D_v=D_o \exp\{-Q_v/RT\} \qquad (2$$

where $Q_v$=71.5 kcal/mol. At 1600_C, $D_v$=6(10)$^{-7}$ cm$^2$/s.

If a void is buried internally in a grain, the closest vacancy sink is a neighboring grain boundary. If the grain size of the material is X, then the time T required for a vacancy to diffuse from the pore to the grain boundary is given approximately by:

$$T=X^2/D_v \qquad (3)$$

Let us consider the case where a piece of CVD material containing voids is annealed at 1600°C where $D_v$=6(10)$^{-7}$ cm$^2$/s. If the annealing time at this temperature is several days ($\sim$10$^5$ s), then microscopic voids in the grains smaller than 2.4mm may have time to anneal away. For larger grains or larger single crystal diamond, the voids will not have time to disappear by vacancy diffusion. Table 1 lists the maximum grain size in which voids can be eliminated vs. temperature for a high-pressure anneal for several days by vacancy diffusion.

Table 1:

| Max. Grain Size vs. Annealing Temperature | |
| --- | --- |
| Grain Size | |
| (microns) | Temp. (_C) |
| 27 | 1000 |
| 76 | 1100 |
| 182 | 1200 |
| 395 | 1300 |
| 779 | 1400 |
| 1424 | 1500 |
| 2441 | 1600 |
| 3960 | 1700 |
| 6130 | 1800 |

CVD diamond is typically grown in a low-pressure gas atmosphere of hydrogen and hydrocarbon and sometimes some additional gases such as oxygen. As a result, the voids in CVD diamond may contain these gases. As the void shrinks, the pressure in the void will increase until the driving force for shrinkage which is given by $\gamma/r$ is balanced by the gas pressure P in the void:

$$P = \gamma/r \qquad (3)$$

where P is the pressure in the void, $\gamma$ is the surface energy of the void and r is the radius of the void. The initial pressure $P_0$ in the void is given by:

$$P_o = P_{cvd}[T_{anneal}/T_{cvd}] \qquad (4)$$

where $P_{cvd}$ is the gas pressure used in the CVD diamond process, $T_{cvd}$ is the substrate temperature of the CVD process and Tanneal is the temperature of the high-pressure anneal.

As the void shrinks from its original radius $r_0$ to a radius r, the gas pressure in the void will increase as:

$$P = P_o(r_o/r)^3 \qquad (5)$$

Equations 3,4 and 5 may be solved for the final radius r beyond which the void will not shrink any further by the mechanism of vacancy diffusion:

$$r = \{(P_{cvd}/\gamma)(T_{anneal}/T_{cvd})r^3_o\}^{1/2}$$

$$(6)$$

$$r_o = \{(T_{anneal}/T_{cvd})R_oP_{cvc}/\gamma)\}^{1/2}$$

Since $T_{anneal} > T_{cvd}$, then if $P_{cvd} > \gamma/r_0$, then no shrinkage of the void is possible by vacancy diffusion. For typical conditions, $P_{cvd} = 10,000$ dyn/cm$^2$ and $\gamma = 5300$ dyn/cm implying that voids larger than 0.5cm would not shrink. Since voids this large are not encountered in CVD diamond, this will not be a limitation.

For more typical voids of about 20 microns in diameter, the final radius to which the void will shrink by vacancy diffusion is 1.73 microns at which point the gas pressure in the void will balance the surface tension of the void and vacancy diffusion will stop. The late stages of void shrinkage to this final radius will be very slow because of the reduction of driving force as the gas pressure in the void increases as the void shrinks. Consequently, another mechanism of void elimination is needed such as plastic flow of the solid. To obtain desirable enhanced properties, it is preferred that the final CVD diamond, which has reduced density gradients, has void sizes of less than less about 10 microns, preferably less than about 5 microns, and more preferably less than about 2 microns.

As an idealization of the actual problem, consider a spherical piece of CVD diamond of radius b with a void at its center with a radius a. If the CVD diamond is placed in a pressure vessel at a pressure P much greater than any residual gas pressure in the void, the radial $\sigma_r$ and the tangential $\sigma_t$ stresses in the CVD diamond are given by:

$$\sigma_r = P[b^3(R^3-a^3)/R^3(a^3-b^3)] \qquad (7)$$
$$\sigma_t = P[b^3(2R^3+a^3)/2R^3(a^3-b^3)] \qquad (8)$$

where R is the radial vector with its origin in the center of the void. Of greatest interest are the stresses near the surface of the void, i.e., at R=a. In this case, the radial stress $\sigma_r$ reduces to zero whereas the tangential stress $\sigma_t$ approaches 1.5P:

$$\sigma_r \rightarrow P[1-(a/R)^3] \rightarrow 0 \text{ as } R \rightarrow a \qquad (9)$$
$$\sigma_t \rightarrow 1.5P \text{ as } R \rightarrow a \qquad (10)$$

This result was derived by Lame in his Lecons sur La Theorie de L'Elasticite in Paris in 1852.

For diamond, the plastic yield strength varies with temperature. DeVries in his paper, Mat Res. Bull., 10, 1193-1200 (1975) gives the variation of the plastic yield stress of diamond vs. temperature in his Figure 5. From this figure above 1100°C the yield stress of diamond is less than 10 kbars. To remain in the diamond stable region at these temperatures the diamond must be at pressures greater than 50kbars. At 50kbars, from eq. 10, we see that the tangential stress on the cavity will be 75kbar which is much greater than the plastic yield strength of 10kbars of diamond above 1100°C. Therefore, the diamond will plastically yield by slip around the cavity and the cavity will collapse and disappear. Slip will occur on the four family of planes of the (111) type in the <110> direction plus one additional unknown plane for reasons outlined below.

For polycrystalline CVD diamond, a further restriction on plastic flow is necessary. When a ductile polycrystal is plastically deformed each grain remains joined to its neighbors and so deforms to a shape dictated by them. Simultaneous slippage on differently oriented slip planes has to occur to allow the grain to deform to the shape demanded by its neighbors. Slip on a single family of parallel planes could not produce the required shape change. Hence, for general three dimensional plasticity of a polycrystalline solid, the crystal must slip on at least five differently oriented and geometrically independent systems. Such a crystal can always conform to the changing shapes of its neighbors.

In diamond, there are independent slip systems on the four different (111) planes in the <110> direction. The critical plastic yield stress from DeVries's reference above is for these four slip systems. Because we need one more slip system for polycrystalline CVD diamond, an additional slip system must come into play. Unfortunately, no one has observed or measured the critical plastic yield stress on such as additional slip system in diamond. If the critical yield stress for this slip system exceeded 75 kbars, plastic yielding would not occur under the above conditions and the voids would not collapse. However, this situation is very unlikely as typical yield stresses on secondary slip systems do not exceed a factor of 1.5 the critical yield stress on the primary slip system. For diamond, this would mean that the critical plastic yield stress necessary for all 5 slip systems would be 15kbars rather than the 10kbars observed by DeVries in the primary (111) slip system.

In accordance with the preferred features of the present invention, starting CVD diamond which may be in the form of a part, or parts, are placed inside a press apparatus and annealed by heat treatment under conditions of extreme high pressure such that the diamond is placed in an environment where it is the thermodynamically stable phase of carbon. Typically this includes temperatures in the range of 1000-2000°C and pressures from 1 GPa up to 20GPa, preferably in the range of 5-7Gpa and temperatures in the range 1400-1700°C.

The conditions of annealing are dependent on the type of defect or density gradient that is to be removed from the diamond body. Density fluctuations caused by cracks or voids can be removed by milder conditions leading to plastic flow. Fluctuations caused by crystalline defects, such as twins or dislocations, can be removed at more aggressive conditions favoring atomic carbon diffusion. Fig. 1 shows a diagram (DeVries) that defines the appropriate regions of pressure and temperature that effect both plastic flow and atomic diffusion within a diamond body. The diamond may be held under high-pressure and -temperature conditions for a period of time ranging from minutes to several days, more typically 1-24 hr, and even more typically from 6-10 hr.

The starting diamond pieces may be placed in inert pressure-transmitting fluids or solids including salts or unreactive metals during the process. The pressure medium used to transmit the pressure from the external surfaces where the force is generated to the diamond surfaces is critically important to the annealing process. The medium must transmit pressure without loss as a continuum onto diamond surfaces in the pressure apparatus. The medium must be thermally and chemically stable in that it can survive annealing conditions of temperature, pressure and time, in the presence of diamond surfaces, without itself being chemical degraded, participating in or catalyzing reactions, or causing dissolution or degradation of the diamond parts or pieces. Suitable media are stable fluids or gases at annealing conditions, or highly plastic solids, including, but not limited to, salts such as sodium chlorides, oxides such as magnesium oxide or carbons such as graphite. The medium must also be sealable to high pressures and temperatures by known methods and possess a volume compressibility which is small and comparable to the gasketting system i.e, it must be void-free and close to its theoretical lattice density at annealing conditions.

In accordance with the present invention, the resulting CVD having reduced density gradients is densified at temperatures and pressures where diamond is the thermodynamic stable phase of carbon. The resulting diamond is characterized by a reduction in the size of the voids. These voids are referred to a compressed voids. It is believed that the reduction in size of the voids is accompanied by an increase in gas pressure within the voids. Initially, the voids in the starting CVD diamond comprise gaseous material at a pressure approximating pressure of the CVD deposition. The final voids or compressed voids in the CVD diamond having reduced density gradients have an internal pressure approximating the pressure of densification minus the yield strength of diamond.

Upon removal of the diamond parts from the high pressure/high temperature anneal, they are ready for fabrication into a electro-optical, acoustic or thermomechanical devices by dicing, polishing or hole drilling by laser or mechanical means or to be implemented in whatever application they were originally intended.

As an alternative to the method described above, it may be desirable to shape, polish, or otherwise finish the diamond parts and then subsequently press. As an alternative to the method described above, annealing of three dimensional parts such as tubes, nozzles, beads, bearings, hemispheres, or other unusually shaped components may take place.

The present invention contemplates any sequence of events commencing with CVD diamond, and completion of part fabrication, in which one or more intermediate steps the treatment of the present invention takes place. The polishing, shaping and dicing sequence can occur in any order at the convenience of the processor.

The present invention also contemplates improving the properties of other types of diamond parts, including single and polycrystalline diamond, specifically including diamond wire dies, tools and wear parts including friction-reducing diamond surfaces, diamond windows, heat sinks, diamond electronic components including those doped at annealing conditions, diamond grit for saws, drills and grinding tools.

For wire die applications, it is desirable to utilized a high purity starting non-opaque CVD diamond that the final product will have desirable properties. Since the densified diamond resulting from the process of the present invention has a purity and other characteristics dependent on the starting diamond material, is preferable to use a starting diamond with certain desirable characteristics so that the final densified diamond may be desirable used in applications requiring high quality diamond. Typically, thickness of the starting CVD diamond for preferred applications is from 0.2 to 10 millimeter, preferably from 0.3 to 1.2 millimeters. Preferred optical properties include an absorbance of less than about 1.6 mil$^{-1}$ when using light having a wavelength in the range between about 300 to 1400 nanometers. Over this range, the absorbance decreases linearly from about 1.6 mil$^{-1}$ to 0.2 mil$^{-1}$ as the wavelength increases from 300 to 1400 nanometers. The absorbance decreases from 0.2 mil$^{-1}$ to less than 0.1 mil$^{-1}$ as the wavelength increases from about 1400nm to about 2400nm.

As previously discussed, a preferred starting CVD diamond for optical applications typically has crystals with a <110> orientation perpendicular to the bottom surface. It is contemplated that the diamond grains may have a random orientation both parallel to the opening and perpendicular to the axial direction of the opening. If the grain size of the CVD diamond is sufficiently small, random crystallographic orientations may be obtained. A preferred starting CVD diamond film for optical applications has the properties described above including, grain boundaries between adjacent diamond crystals preferably have hydrogen atoms saturating dangling carbon bonds as illustrated in the patent. Preferred, starting CVD diamond has a hydrogen concentration of less than 2000, preferably less than 900 ppm. The concentrations of hydrogen in atomic per cent are typically from 10 ppm to about 1000 ppm, preferably from about 10 ppm to 500 ppm. A preferred starting diamond body has no voids greater than 20, and preferably greater than 10 microns in diameter or inclusions of another material or carbon phase.

A preferred starting CVD diamond film for optical applications is non-opaque or transparent or translucent and contains oxygen in atomic percent greater than 1 part per billion. Undesirable impurities in the form of catalyst material, such as iron, nickel, or cobalt are preferably present in amounts less than 10 parts per million in atomic per cent. These impurities are typically associated with competing high-pressure high-temperature diamond synthesis process. Nitrogen may be present in the CVD diamond film in atomic per cent from between 0.1 to 1000 parts per million.

When preferred starting CVD diamond films are produced by deposition on substrates made of Si, Ge, Nb, V, Ta, Mo, W, Ti, Zr or Hf, by neutron activation analysis, we have found that small amounts of these substrate materials are incorporated into the CVD diamond films made on these substrates. Hence, the film may contain greater than 10 parts per billion and less than 10 parts per million of Si, Ge, Nb, V, Ta, Mo, W, Ti, Zr or Hf. Additionally, the film may contain more than one part per million of a halogen, i.e. fluorine, chlorine, bromine, or iodine. Additional additives may include N, B, O, and P which may be present in the form of intentional additives. These latter materials may be added as intentional additives during the growth process.

By way of further explanation, boron can be an intentional additive that is used to reduce intrinsic stress in the CVD diamond film or to improve the oxidation resistance of the film. Typically boron may present in atomic per cent from between 1-4000 ppm. Preferably additives such as N, S, Ge, Al, and P, are each present at levels less than 100 ppm. It is contemplated that suitable films may be produced at greater levels. Lower levels of impurities tend to favor desirable properties of toughness and wear resistance. The most preferred films contain less than 5 parts per million and preferably less than 1 part per million impurities and intentional additives. In this regard, hydrogen, nitrogen, and oxygen are not regarded as intentional additives or impurities since these ingredients are the result of the process. As previously set forth, the present invention contemplates production of such high purity starting CVD diamond by a variety of techniques such as microwave CVD, RFCVD, DCjet CVD, hot filament CVD, or combustion flame CVD.

Example #1:

An as-grown CVD wafer about 2 mm diameter and ~0.5mm thick was broken in half; one piece was placed between graphite foil sheets, and annealed at ~50kbar and 1300_C for 15mins in KCl powder. At these conditions the KCl salt is not molten; pressure is applied through the graphite foil onto the diamond wafer. The pressure across the wafer surface will be distributed uniformly by the facile plastic deformation of the foil. A comparison of optical microscope images of a portion of a wafer prior to stress annealing with a portion of the same wafer after stress annealing highlighs differences due to the annealing. Examination of the same wafers through transmission crossed-polarized light highlights the strain field within the non-annealed portion as evidenced by birefringence. Dark and light areas of various colors are evident. The annealed portion is stress reduced as evidenced by the decreased birefringence evidenced by uniformity in polarized light The strain has been reduced from the more darkly shaded and strained regions. The absence of dark areas in the treated CVD diamond is evidence of stress relief. The stress present in the untreated diamond causes birefringence in the diamond and the variable multicolor pattern.

## Claims

1. A process for producing a diamond body having reduced density and stress gradients comprising treating a chemically vapor deposited diamond body of the type having voids at sufficient temperatures and pressures wherein diamond is the thermodynamically stable phase of carbon to reduce the size of the voids to form a diamond body of reduced density and stress gradients.

2. A process for producing a diamond body according to claim 1 wherein said diamond body of the type having voids comprises a starting diamond having voids containing a low pressure gaseous material.

3. A process for producing a diamond body according to claim 2 wherein said diamond body of reduced density gradients comprises a densified diamond body having voids containing a gaseous material at a higher pressure than said starting diamond.

4. A process for producing a diamond body according to claim 3 wherein said starting diamond is treated at said sufficient temperatures and pressures to reduce the size of said voids to produce said densified diamond.

5. A process for producing a diamond body according to claim 4 wherein said starting diamond body is treated at high pressure and high temperature conditions in the range of 1000-2500°C and pressures from 1GPa up to 20GPa.

6. A process for producing a diamond body according to claim 5 wherein said starting diamond comprises substantially transparent columns of diamond crystals having a predominance of but not exclusively <110>,<100> or <111> orientation.

7. A process for producing a diamond body according to claim 5 wherein said starting diamond has grain boundaries between adjacent diamond crystals having substantially saturated dangling carbon bonds.

8. A process for producing a diamond body according to claim 5 wherein said gaseous containing voids comprise a gaseous mixture comprising hydrogen, and carbon.

9. A process for producing a diamond body according to claim 5 wherein said starting diamond comprises impurities or intentional additives in amounts less than less than 4000 parts per million.

10. A chemically vapor deposited diamond body having reduced density and stress gradients comprising a low pressure chemically vapor deposited diamond body having compressed voids comprising a gaseous material.

FIGURE 1

EP 0 671 482 A1

European Patent Office

**EUROPEAN SEARCH REPORT**

Application Number

| | DOCUMENTS CONSIDERED TO BE RELEVANT | | EP 95301368.7 |
|---|---|---|---|

| Category | Citation of document with indication, where appropriate, of relevant passages | Relevant to claim | CLASSIFICATION OF THE APPLICATION (Int. Cl. 6) |
|---|---|---|---|
| A | US - A - 5 271 971<br>(JOHN A. HERB et al.)<br>    * Abstract; claims 1,2 *<br>-- | 1-10 | C 23 C 16/26<br>B 05 D 3/06<br>B 01 J 3/06 |
| A | US - A - 5 273 790<br>(JOHN A. HERB et al.)<br>    * Abstract; claims 1-11 *<br>-- | 1-10 | |
| A | US - A - 4 882 138<br>(JOHN M. PINNEO)<br>    * Abstract; claims 1-7 *<br>---- | 1-10 | |
| | | | TECHNICAL FIELDS SEARCHED (Int. Cl. 6)<br><br>C 23 C<br>B 05 D<br>B 01 J |

The present search report has been drawn up for all claims

| Place of search | Date of completion of the search | Examiner |
|---|---|---|
| VIENNA | 02-06-1995 | HAUK |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)

11